# EUROPÄISCHE PATENTSCHRIFT

(11) **EP 0 815 455 B1**
(45) Veröffentlichungstag und Bekanntmachung des Hinweises auf die Patenterteilung: **02.05.2001**
(21) Anmeldenummer: 96905675.3
(22) Anmeldetag: 29.02.1996
(51) Int. Cl.: G01R 15/14

(54) **AKTIVES OPTISCHES STROMMESS-SYSTEM**
ACTIVE OPTICAL CURRENT MEASURING SYSTEM
SYSTEME OPTIQUE ACTIF DE MESURE DU COURANT

(30) Priorität: 23.03.1995 DE 19510662
(43) Veröffentlichungstag der Anmeldung: 07.01.1998
(73) Patentinhaber: SIEMENS AKTIENGESELLSCHAFT, 80333 München (DE)
(72) Erfinder: ECKARDT, Dieter, D-91074 Herzogenaurach (DE)
(86) Internationale Anmeldenummer: DE9600358
(87) Internationale Veröffentlichungsnummer: WO9629608

(56) Entgegenhaltungen:
- WO-A-92/13277
- US-A- 4 070 572
- US-A- 5 461 307

## Beschreibung

Die Erfindung bezieht sich auf ein aktives optisches Strommeßsystem.

Die Zwischenkreisspannungen in Großstromrichtern liegen heute bereits bei ca. 5 kV mit der Tendenz hin zu 10 kV und 20 kV. Derartig hohe Zwischenkreisspannungen stellen auch hohe Anforderungen an die Isolationsfestigkeit der verwendeten Strom- und Spannungswandler. Die Teilentladungsfestigkeit ist dabei die entscheidende Bemessungsgröße für die Isolationsfestigkeit. Bei 5 kV Zwischenkreisspannung muß eine Teilentladungsfestigkeit von 20 kV gefordert werden.

Die heute verwendeten Wandlersysteme sind kompensierende Stromwandler. Zur Einhaltung der geforderten Teilentladungsfestigkeit müssen diese Wandler jedoch spezielle Herstellungsprozesse durchlaufen, die die Wandler sehr verteuern. Dazu kommt, daß diese Wandler einen großen Bauraum beanspruchen und die Leitungen zur Stromversorgung des Wandlers sowie zur Übertragung der Meßsignale unter Einhaltung der vorgeschriebenen Luft- und Kriechstrecken verlegt werden müssen, um eine sichere Trennung zu garantieren. Dadurch vergrößert sich der notwendige Bauraum weiter.

Da die Wandler bereits eine Teilentladungsfestigkeit von 20 kV bei einer Zwischenkreisspannung von 5 kV kaum mehr garantieren können, scheint eine immer aufwendigere Isolation nicht der geeignete Weg zu sein, um die Wandlersysteme für noch höhere Zwischenkreisspannungen bei einem gleichzeitig niedrigen Preisniveau zu ertüchtigen.

Ein grundsätzlich anderer Ansatz zur Lösung dieses Problems ist, die sichere Trennung mittels Lichtleiter durchzuführen. Das bedeutet allerdings, daß sensorseitig eine Elektronik notwendig ist, die zumindest die vom Sensor gelieferten Meßsignale verstärkt und einen Lichtleitersender ansteuert. Die Energieversorgung dieser Elektronik muß dann aber ebenfalls über einen Lichtleiter erfolgen. Derartige Energieübertragungssysteme bestehen aus einem Laser, dem Lichtwellenleiter und einem Energiekonverter. Die übertragbare Leistung ist allerdings auf einige 100 mW beschränkt. Aus diesem Grunde kann in solchen lichtenergieversorgten Systemen kein kompensierender Stromwandler eingesetzt werden, da der Leistungsbedarf dieser Wandler aufgrund des Kompensationsstromes zu groß ist.

Aus dem Aufsatz "Optische Stromwandler - erster Feldversuch im 380-kV-Netz erfolgreich", abgedruckt in der DE-Zeitschrift "ABB Technik", Band 3, 1994, Seiten 12 bis 18, ist ein aktives optisches Strommeßsystem bekannt. Dieser Aufsatz stellt verschiedene optische Stromwandler vor, die unter realen Bedingungen in einem deutschen 380 kV-Netz getestet wurden. Der aktive Stromwandler arbeitet im wesentlichen nach dem Prinzip einer konventionellen Strommessung, ergänzt durch eine digitale optische Übertragungsstrecke. Im einzelnen besteht das System aus einer Luftkernspule einschließlich Bürde, einem Analog-Digital-Wandler und einer Sendeeinheit mit lichtemittierender Diode auf hohem Potential. Ein Lichtwellenleiter stellt die Verbindung zum Schnittstellengerät auf Erdpotiental her. Die Elektronik auf hohem Spannungspotential, als Niederenergie CMOS-Schaltung aufgebaut, hat weniger als 150 µW Leistungsbedarf. Als Energieversorgung genügt eine Laserdiode, die zwischen zwei Datentelegrammen über den gleichen Lichtwellenleiter Energie sendet. Bei größeren Entfernungen zwischen Sensor und Schnittstellengerät wird wegen der höheren Sendeleistung ein paralleler Lichtwellenleiter zur Energieversorgung benötigt.

Im Aufsatz "EHV Series Capacitor Banks. A New Approach To Platform To Ground Signalling, Relay Protection and Supervision", abgedruckt in der Zeitschrift IEEE Transactions on Power Delivery, Vol. 4, No. 2, April 1989, Seiten 1369 bis 1378, wird die Verwendung des vorgestellten aktiven Stromwandlers bei einem Serienkompensator beschrieben. Diesem Aufsatz ist neben dem Aufbau des aktiven Stromwandlers auch der Aufbau der Sensorelektronik und des Schnittstellengerätes auf Erdpotential zu entnehmen. Die Sensorelektronik besteht aus einem Filter, mehreren Spannungsteilern und einem Energiekonverter. Das Schnittstellengerät besteht aus einem Empfänger, einer Grenzwertschaltung, einem Detektor, einem Puffer und aus einem Pulsgenerator, einem Sender und einer Lichtweiche. Da der aktive Stromwandler zur Strommessung eine Luftkernspule mit Bürde verwendet, können mit diesem aktiven Stromwandler nur Wechselströme erfaßt werden.

Ein Stromsensor, der auch Gleichströme erfassen kann und selbst keine Energieversorgung benötigt, ist ein Meßwiderstand oder Shunt.

Aus der US-PS 4,070,572 ist ein Strommeßsystem bekannt, das einen Shunt, eine Sendeelektronik, eine Empfängerelektronik und eine Stromversorgungseinrichtung aufweist. Der Shunt ist in einer Hochspannungs-Wechselstromleitung angeordnet. Die Sendeelektronik ist eingangsseitig mit den Enden dieses Shunts verbunden und in unmittelbarer Nähe dieses Shunts angeordent. Die Stromversorgungseinrichtung koppelt aus der Hochspannungs-Wechselstromleitung Energie für die Sendeeinrichtung aus. Mittels eines Lichtwellenleiters gelangt das analoge Meßsignal zur Empfangseinrichtung auf Endpotential.

Da die Meßsignale des Shunts im Interesse einer niedrigen Verlustleistung klein gehalten werden müssen, sollte eine Sensorelektronik in unmittelbarer Umgebung des Shunts angeordnet werden, um Störungen weitgehend auszuschließen. Der Betrieb dieser Elektronik findet dann in elektromagnetisch rauher Umgebung statt, das heißt, sie wird von starken und unter Umständen schnell veränderlichen elektrischen und magnetischen Feldern beaufschlagt. Daneben ist die Elektronik in der Regel relativ hohen Temperaturen ausgesetzt. Ein Nachteil des Meßwiderstandes besteht darin, daß dieser für einen Abgleich mechanisch bearbeitet werden muß.

Aus der WO 92/13277 ist ein Stromwandler zur Messung von Über- oder Kurzschlußströmen in einer gasisolierten, metallgekapselten Schaltanlage mit mindestens einem auf Hochspannungspotential befindlichen Leiter bekannt. Dieser Leiter wird mittels eines scheibenförmigen Stützisolators zwischen der Außenkapselung gehalten. der Leiter auf Hochspannungspotential ist rohrförmig ausgestaltet. Um diesen Leiter ist der Stromwandler herum angeordnet. Dazu weist der Leiter eine am Außenumfang umlaufende Vertiefung auf, die von dem Rohrstück des Stromwandlers, dessen Außendurchmesser dem Außendurchmesser des Innenleiters gleicht, abgedeckt wird. Die Länge dieses dünnwandigen Rohrstückes richtet sich nach der gewünschten Strommeßempfindlichkeit. Der Spannungsabfall über dem Rohrstück wird durch Leitungen der Anschlußleiter abgegriffen und einer im Inneren des Innenleiters befindlichen Wandlerschaltungsanordnung zugeführt. Der zwischen dem dünnwandigen Rohrstück und dem Boden der Vertiefung (Nut) befindliche Innenraum kann mit einem festen Isolierstoff ausgefüllt werden. Außerdem richtet sich die Tiefe dieser Vertiefung nach der Frequenz des zu messenden transienten Kurzschlußstromes. Je höher die Frequenz, desto kleiner die Tiefe dieser Vertiefung.

Der Erfindung liegt nun die Aufgabe zugrunde, ein aktives optisches Strommeßsystem anzugeben, mit dem auch Gleichströme erfaßt werden können und dessen Sensorelektronik gegen Störungen geschützt ist.

Diese Aufgabe wird erfindungsgemäß gelöst mit den Merkmalen des Anspruchs 1.

Dadurch, daß der Sensor aus zwei Teilen besteht, die im zusammengesetzten Zustand einen Hohlraum aufweisen, in dem die Sensorelektronik untergebracht ist, und als Sensor einen Meßwiderstand vorgesehen ist, bildet dieser Meßwiderstand (Shunt) das Gehäuse für die Sensorelektronik. Dieser Aufbau gewährleistet den mechanischen Schutz der Elektronik und verhindert, daß hochfrequente Störungen auf die Elektronik einwirken können, da der Shunt als elektromagnetische Abschirmung wirkt. Die eigentlichen Sensorsignale werden an der Innenseite des Shunts abgegriffen.

Bei einer vorteilhaften Ausführungsform des aktiven optischen Strommeßsystems ist die Sensorelektronik im Inneren des Shunts eingangsseitig mit zwei räumlich dicht beieinanderliegenden Meßpunkten verknüpft, wobei der erste Meßpunkt ein Punkt der Innenseite des Sensors ist und der zweite Meßpunkt mittels einer entlang der Innenseite des Sensors isoliert geführten Leitung mit einem weiteren Punkt der Innenseite des Sensors verbunden ist, wobei dieser weitere Punkt derart gewählt ist, daß der zweite Meßpunkt und dieser weitere Meßpunkt räumlich relativ weit auseinanderliegen. Mittels dieser isoliert geführten Leitung wird das am weiteren Punkt anliegende Potential am Shunt niederinduktiv an den zweiten Meßpunkt übertragen. Auf diese Art und Weise erhält man als Meßspannung immer genau die Spannung, die dem durch den Strom hervorgerufenen Spannungsabfall an der geschlossenen Leiterschleife entlang des Weges der Meßleitung entspricht.

Bei einer besonders vorteilhaften Ausführungsform ist der zweite Meßpunkt mittels mehrerer entlang der Innenseite des Sensors isoliert geführter Leitungen mit dem weiteren Punkt der Innenseite des Sensors verbunden, die einen Käfig bilden. Durch diese Ausgestaltung der mehreren Meßleitungen zu einem Käfig wird die Störsicherheit gegenüber äußeren Störfeldern wesentlich erhöht.

Bei einer weiteren vorteilhaften Ausführungsform weist die Sensorelektronik elektronisch steuerbare Potentiometer auf. Dadurch wird ein elektronischer Offset- und Verstärkungsabgleich ermöglicht. Dadurch kann der Shunt zunächst gefertigt, die Elektronik eingesetzt und das Strommeßsystem ohne mechanische Bearbeitung abgeglichen werden. Die jeweiligen Schleifenpositionen der elektronisch steuerbaren Potentiometer werden abgespeichert. Beim Einschalten des aktiven optischen Strommeßsystems wird die gespeicherte Position automatisch wieder ausgelesen und die Potentiometer werden justiert.

Der Abgleich dieses Strommeßsystems erfolgt hinsichtlich Nullpunkt und Verstärkung bzw. Übertragungsbeiwert. Die Übertragung der Signale zum Verstellen der elektronisch steuerbaren Potentiometer können sowohl über einem Shunt angebrachte Steckverbindung erfolgen als auch dadurch, daß das vom Sender der Auswerteelektronik auf Erdpotential gesendete Licht moduliert und die Information auf der Sensorelektronik zurückgewonnen wird. Der Abgleich läßt sich vollautomatisch durchführen.

Zur weiteren Erläuterung der Erfindung wird auf die Zeichnung Bezug genommen, in der ein Ausführungsbeispiel des aktiven optischen Strommeßsystems schematisch veranschaulicht ist.
- Figur 1: zeigt den konstruktiven Aufbau des erfindungsgemäßen Strommeßsystems, die
- Figur 2: zeigt das Blockschaltbild der Sensorelektronik des Strommeßsystems nach Figur 1, in
- Figur 3: ist die Ermittlung des Sensorsignals dargestellt und die
- Figur 4: veranschaulicht den vereinfachten Kompensationskäfig.

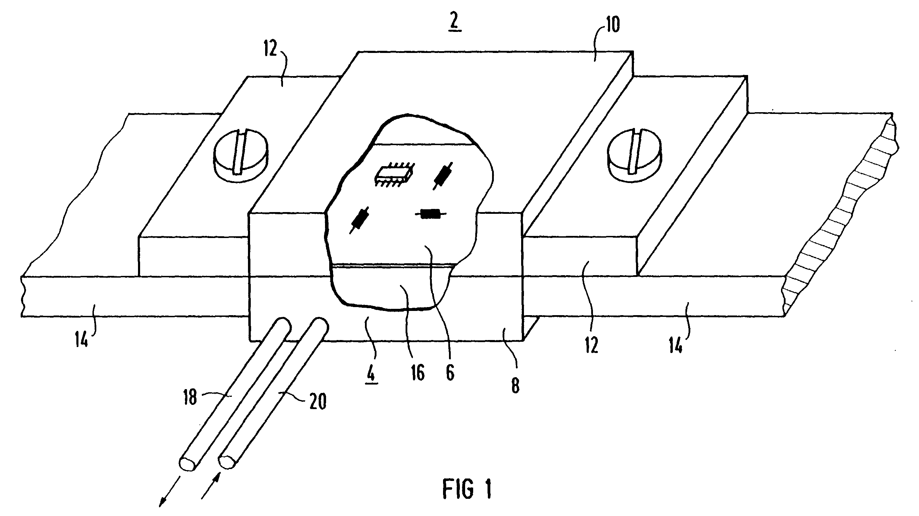

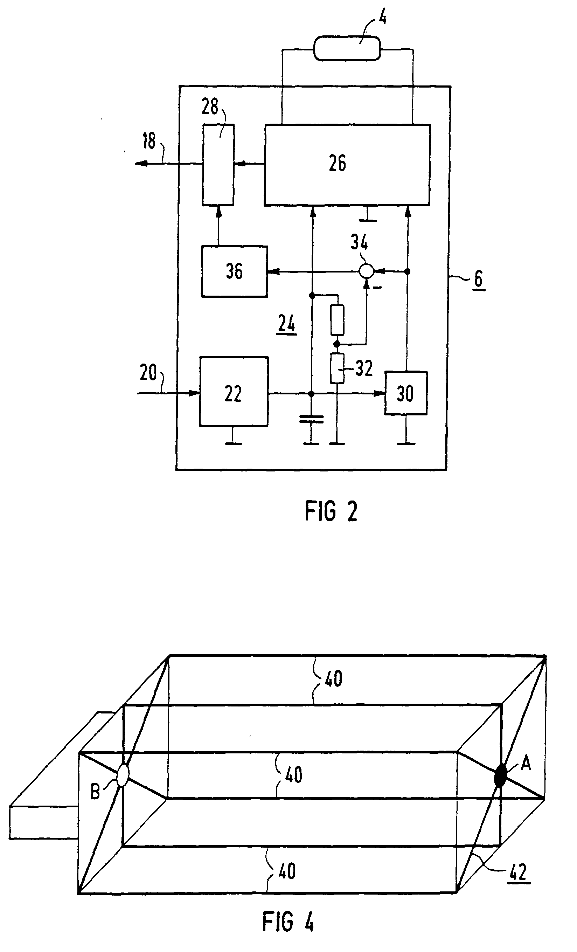

Die Figur 1 zeigt den konstruktiven Aufbau des erfindungsgemaßen aktiven optischen Strommeßsystems 2, der aus einem Sensor 4 und einer Sensorelektronik 6 besteht. Als Sensor 4 ist ein Meßwiderstand (Shunt) vorgesehen, der aus zwei Teilen 8 und 10 besteht. Diese Teile 8 und 10 sind stirnseitig jeweils mit einer Strom-Anschlußschiene 12 bzw. 14 versehen. Außerdem sind diese Shuntteile 8 und 10 dermaßen ausgebildet, daß im zusammengebauten Zustand der Shunt 4 einen Hohlraum 16 aufweist. In diesem Hohlraum 16 ist die Sensorelektronik 6 angeordnet. Der Shunt 4 bildet praktisch das Gehäuse für die Sensorelektronik 6, deren Blockschaltbild in Figur 2 näher dargestellt ist. Die beiden Teile 8 und 10 des Shunts 4 bestehen vorzugsweise aus Manganin, wogegen die Strom-Anschlußschienen 12 und 14 aus Kupfer bestehen. Die Strom-Anschlußschienen 12 bzw. 14 sind mit dem Teil 10 bzw. 8 beispielsweise hartverlötet. Diese Strom-Anschlußschienen 12 und 14 dienen einerseits zur Verbindung der beiden Shuntteile 8 und 10 und andererseits zur Befestigung in einer Stromschiene, beispielsweise einer Stromschiene eines Zwischenkreises eines Großstromrichters. Zur Verbindung der beiden Shuntteile 8 und 10 werden die Strom-Anschlußschienen 12 und 14 miteinander verschraubt oder miteinander vernietet oder miteinander verschweißt. Der Sensor 4 ist außerdem mit zwei Lichtwellenleiter-Anschlüssen versehen, die bei dieser Darstellung nicht näher veranschaulicht sind. In diese Lichtwellenleiter-Anschlüsse werden die beiden Lichtwellenleiter 18 und 20 gesteckt, wobei der Lichtwellenleiter 18 für die Übertragung des Datenstromes bzw. des Mischsignals, bestehend aus einem PWM-Signal und einem Datensignal, und der Lichtwellenieiter 20 für die Übertragung der Energie für die Sensorelektronik 6 zuständig ist. Dieser Aufbau des aktiven optischen Strommeßsystems gewährleistet den mechanischen Schutz der Sensorelektronik 6 und verhindert, daß hochfrequente Störungen auf die Sensorelektronik 6 einwirken können, da der Shunt 4 als elektromagnetische Abschirmung wirkt.

In der Figur 2 ist das Blockschaltbild der Sensorelektronik 6 näher dargestellt. Diese Sensorelektronik 6 besteht aus einem Energiekonverter 22, einer Meßeinheit 24, einer Verarbeitungselektronik 26 und einer digitalen Mischeinrichtung 28. Die Meßeinheit 24, die zur Regelung der Versorgungsspannung der Verarbeitungselektronik 26 dient, weist einen Referenzwertgeber 30, einen Spannungsteiler 32, einen Vergleicher 34 und einen PWM-Modulator 36 auf. Mittels des Lichtwellenleiters 20 gelangt Energie in Form von Laserlicht zum Energiekonverter 22, der dieses Licht wieder in elektrische Energie umwandelt. Die vom Energiekonverter 22 aufgebaute Spannung dient direkt, also ohne zusätzliche Spannungsregelung vor Ort, zur Stromversorgung der Verarbeitungselektronik 26, die eingangsseitig mit dem Sensor 4 verknüpft ist. Damit dennoch die Versorgungs-spannung der Verarbeitungselektronik 26 konstant gehalten werden kann, wird diese Spannung gemessen und mit einer Referenzspannung verglichen. Die Differenz wird pulsbreiten-moduliert und mit Hilfe der Mischeinrichtung 28, insbesondere einem Multiplexer, zusammen mit dem von der Verarbeitungselektronik 26 gelieferten Datenstrom an die Auswerteelektronik der Schnittstellenbaugruppe auf Erdpotential übertragen. Dort werden das eigentliche Meßsignal und das PWM-Signal wieder getrennt. Während das Meßsignal an einen Prozessor weitergeleitet wird, wird das PWM-Signal als Eingangssignal an einen Regler gelegt, der die Leistung des Senders so verändert, daß die Spannung, die der Energiekonverter 22 aufbaut, konstant gehalten wird.

Eine genaue Beschreibung dieser Sensorelektronik 6 und deren Funktionsweise ist einer parallel eingereichten deutschen Patentanmeldung mit dem amtlichen Aktenzeichen 195 10 660.1 zu entnehmen.

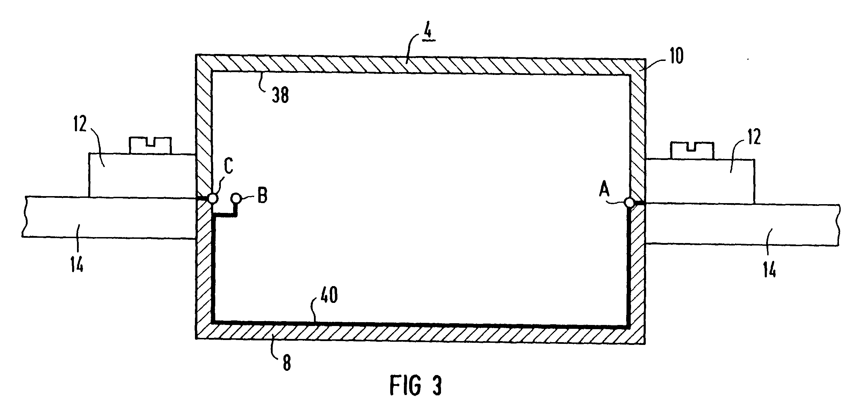

Die eigentlichen Sensorsignale werden an der Innenseite 38 des Shunts 4 abgegriffen. Aufgrund des mechanischen Aufbaus ist der Spannungsabfall über einen Shunt 4 immer nur zwischen zwei räumlich relativ weit auseinanderliegenden Punkten A und C abgreifbar (Figur 3). Um die Meßspannung in einer Elektronik 6, in dieser Darstellung wegen der Übersichtlichkeit nicht näher dargestellt, verarbeiten zu können, muß die Meßspannung aber einem Verstärker zugeführt werden, dessen Anschlüsse im allgemeinen räumlich dicht beieinander liegen. Somit muß die Meßspannung über eine Leitung 40 geführt werden. Diese Leitung 40 ist isoliert eng an der Innenseite 38 des Shunts 4 verlegt. Diese Leitung 40 dient dazu, das am Punkt A anliegende Potential am Shunt niederinduktiv an einen Punkt B zu übertragen. Der Meßpunkt B ist räumlich dicht bei dem Meßpunkt C angeordnet. Zwischen diesen beiden Punkten B und C kann das eigentliche Sensorsignal abgegriffen und der Sensorelektronik 6 zugeführt werden.

Zur Vermeidung eines Störeinflusses muß sichergestellt werden, daß zwischen der geschlossenen Leiterschleife (Innenseite 38 des Shunts 4) und der Meßleitung 40 keine offene Leiterschleife existiert. Diese Bedingung läßt sich nur durch eine geschlossene Meßleiterschleife erfüllen, die praktisch deckungsgleich mit der ersten Leiterschleife ist, aber isoliert von dieser. Lediglich am Punkt A sind beide Leiterschleifen miteinander verbunden.

Allerdings ist diese Störkompensation an eine Bedingung geknüpft, denn ein Störfeld, das die äußere Leiterschleife durchsetzt und in dieser einen Strom induziert, durchdringt auch die Meßleiterschleife und induziert ebenfalls einen Kreisstrom in dieser Leiterschleife. Eine vollständige Kompensation des äußeren Störfeldes ergibt sich deshalb nur, wenn das Verhältnis der Teilwiderstände der Leiterschleife und der Meßleiterschleife gleich sind. Nur in diesem Fall sind die durch die induzierten Ströme hervorgerufenen Spannungsabfälle in der äußeren Leiterschleife (Innenseite 38 des Shunts) und der Meßleiterschleife gleich und heben sich auf.

Damit man eine Meßleiterschleife erhält, muß eine weitere Meßleitung 40 vorgesehen sein, die im Punkt A mit der ersten Meßleitung 40 und mit dem Shunt 4 und mit der ersten Meßleitung 40 am Punkt B verbunden ist (Figur 4). Da der Shunt 4 dreidimensional ist, können die Störfelder in jeder Raumrichtung auf den Shunt 4 einwirken und entsprechende Wirbelströme induzieren. Die Meßleiterschleife muß deshalb ebenfalls dreidimensional gestaltet sein. Diese nimmt nun die Form eines Käfigs 42 an gemäß Figur 4, der sich an der Innenseite 38 des Shunts anschmiegt, aber von diesem isoliert ist. Im Idealfall bildet der Käfig 42 ein geschlossenes Gehäuse. Bereits mit einem symmetrischen, aus nur sechs Einzelleitern 40 bestehenden Käfig 42 wird eine Störkompensation von ca. 90% gegenüber einer einzigen Leiterschleife erreicht. Wie in Figur 4 angedeutet ist, verlaufen die einzelnen Leiter 40 des Käfigs 42 in Richtung des äußeren Stromflusses. Zwar können dadurch keine Wirbelströme quer zur Stromflußrichtung kompensiert werden, diese tragen aber in erster Näherung nicht zu einer Verfälschung der Meßspannung des Shunts 4 bei.

Die Verarbeitungselektronik 26, die aus einer eingangsseitigen Verstärkerschaltung und einem ausgangsseitigen Analog-Digital-Wandler besteht, ist so gestaltet, daß ein elektronischer Offset- und Verstärkungsabgleich ermöglicht wird. Dadurch kann der Shunt 4 zunächst gefertigt werden, die Sensorelektronik 6 eingesetzt und das aktive optische Strommeßsystem 2 ohne mechanische Bearbeitung abgeglichen werden. Für den elektronischen Abgleich des Strommeßsystems 2 befinden sich in der Verstärkerschaltung der Verarbeitungselektronik 26 elektronisch steuerbare Potentiometer. Die jeweilige Schleiferposition wird am Ende des Abgleichs abgespeichert. Beim Einschalten wird die gespeicherte Schleiferposition automatisch wieder ausgelesen und das Potentiometer justiert. Die Übertragung der Signale zum Verstellen der Potentiometer kann sowohl über eine am Shunt angebrachte Steckverbindung erfolgen als auch dadurch, daß das vom Energiekonverter 22 empfangene Licht moduliert ist und die Information in der Sensorelektronik 6 zurückgewonnen wird. Der Abgleich läßt sich vollautomatisch durchführen.

## Patentansprüche

1. Aktives optisches Strommeßsystem (2), bestehend aus einem mit Strom-Anschlußschienen (12, 14) und einem Lichtwellenleiter-Anschluß versehenen Sensor (4), der aus zwei Teilen (8, 10) besteht, die zusammengesetzt einen Hohlraum (16) aufweisen, und einer Sensorelektronik (6), die in diesem Hohlraum (16) untergebracht ist und ausgangsseitig mit dem Lichtwellenleiter-Anschluß verknüpft ist, wobei der Sensor (4) ein Meßwiderstand ist.

2. Aktives optisches Strommeßsystem (2) nach Anspruch 1, wobei die im Hohlraum (16) angeordnete Sensorelektronik (6) eingangsseitig mit zwei räumlich dicht beieinanderliegenden Meßpunkten (C, B), an denen eine Meßspannung abgreifbar ist, verknüpft ist, wobei der erste Meßpunkt (C) ein Punkt der Innenseite (38) des Sensors (4) ist und der zweite Meßpunkt (B) mittels einer entlang der Innenseite (38) des Sensors (4) isoliert geführten Leitung (40) mit einem weiteren Punkt (A) der Innenseite (38) des Sensors (4) verbunden ist, wobei dieser weitere Punkt (A) derart gewählt ist, daß der zweite Meßpunkt (B) und der weitere Punkt (A) räumlich relativ weit auseinanderliegen.

3. Aktives optisches Strommeßsystem (2) nach Anspruch 2, wobei der zweite Meßpunkt (B) mittels mehrerer entlang der Innenseite (38) des Sensors (4) isoliert geführter Leitungen (40) mit dem weiteren Punkt (A) der Innenseite (38) des Sensors (4) verbunden ist.

4. Aktives optisches Strommeßsystem (2) nach Anspruch 3, wobei die mehreren Leitungen (40) in Richtung des zu messenden, durch den Sensor (4) fließenden Stromes verlaufen und einen Käfig (42) bilden.

5. Aktives optisches Strommeßsystem (2) nach Anspruch 4, wobei der Käfig (42) ein geschlossenes Gehäuse bildet.

6. Aktives optisches Strommeßsystem (2) nach Anspruch 1, wobei die Sensorelektronik (6) für seinen elektronischen Abgleich elektronisch steuerbare Potentiometer aufweist.

7. Aktives optisches Strommeßsystem (2) nach Anspruch 1, wobei die Teile (8, 10) des Sensors (4) jeweils mit Strom-Anschlußschienen (12,14) versehen sind.

8. Aktives optisches Strommeßsystem (2) nach Anspruch 1, wobei der Sensor (4) aus Manganin ist.

9. Aktives optisches Strommeßsystem (2) nach Anspruch 7, wobei die Strom-Anschlußschienen (12, 14) aus Kupfer sind.

10. Aktives optisches Strommeßsystem (2) nach Anspruch 1, wobei der Sensor (4) mit einem weiteren Lichtwellenleiter-Anschluß versehen ist.

## Claims

1. Active optical current measuring system (2) consisting of a sensor (4) provided with current terminal rails (12, 14) and an optical waveguide terminal, the said sensor consisting of two parts (8, 10) which when assembled form a cavity (16), and an electronic sensor circuit (6) fitted in this cavity (16) with its output end connected to the optical waveguide terminal, whereby the sensor (4) is a measuring resistor.

2. Active optical current measuring system (2) in accordance with claim 1, whereby the input end of the electronic sensor circuit (6) fitted in the cavity (16) is connected to two measuring points (C, B) positioned spatially close together, at which a measuring voltage can be tapped off, whereby the first measuring point (C) is a point on the inside (38) of the sensor (4) and the second measuring point (B) is connected by a lead (40) passing, insulated, along the inside (38) of the sensor (4) to a further point (A) of the inside (38) of the sensor (4), whereby this further point (A) is chosen so that the second measuring point (B) and the further point (A) are spatially relatively far apart.

3. Active optical current measuring system (2) in accordance with claim 2, whereby the second measuring point (B) is connected by means of several insulated leads (40) passing along the inside (38) of the sensor (4) to the further point (A) of the inside (38) of the sensor (4).

4. Active optical current measuring system (2) in accordance with claim 3, whereby the several leads (40) run in the direction of the current to be measured flowing through the sensor (4) and form a cage (42).

5. Active optical current measuring system (2) in accordance with claim 4, whereby the cage (42) form a closed housing.

6. Active optical current measuring system (2) in accordance with claim 1, whereby the electronic sensor circuit (6) has electronically controlled potentiometers for its electronic calibration.

7. Active optical current measuring system (2) in accordance with claim 1, whereby the parts (8, 10) of the sensor (4) are each provided with a current terminal rail (12, 14).

8. Active optical current measuring system (2) in accordance with claim 1, whereby the sensor (4) is made of manganese.

9. Active optical current measuring system (2) in accordance with claim 7, whereby the current terminal rails (12, 14) are made of copper.

10. Active optical current measuring system (2) in accordance with claim 1, whereby the sensor (4) is provided with a further optical waveguide terminal.

## Revendications

1. Système (2) optique actif de courant, constitué d'un capteur (4) muni de rails (12, 14) de raccordement du courant et d'un raccord à fibre optique constitué de deux parties (8, 10) qui, rassemblées, comportent une cavité (16) et d'une électronique (6) de capteur, qui est logée dans cette cavité et qui est reliée du côté de la sortie au raccord de la fibre optique, le capteur (4) étant une résistance de mesure.

2. Système (2) optique actif de mesure de courant suivant la revendication 1, dans lequel l'électronique (6) de capteur disposée dans la cavité (16) est connectée du côté de l'entrée à deux points (C, B) de mesure étroitement côte à côte dans l'espace et sur lesquels ont peut prendre une tension de mesure, le premier point (C) de mesure étant un point du côté (38) intérieur du capteur (4) et le deuxième point (B) de mesure étant relié à un autre point (A) du côté (38) intérieur du capteur au moyen d'une ligne (40) passant le long du côté (38) intérieur du capteur en étant isolée, cet autre point (A) étant choisi de façon que le deuxième point (B) de mesure et l'autre point (A) soient relativement loin l'un de l'autre dans l'espace.

3. Système (2) optique actif de mesure de courant suivant la revendication 2, dans lequel le deuxième point (B) de mesure est relié au moyen de plusieurs lignes (40) passant, en étant isolées, le long du côté (38) intérieur du capteur à l'autre point (A) du côté (38) intérieur du capteur (4).

4. Système (2) optique actif de mesure de courant suivant la revendication 3, dans lequel les plusieurs lignes (40) s'étendent en direction du courant à mesurer qui passe dans le capteur (4) et forment une cage (42).

5. Système (2) optique actif de mesure de courant suivant la revendication 4, dans lequel la cage (42) forme une enveloppe fermée.

6. Système (2) optique actif de mesure de courant suivant la revendication 1, dans lequel l'électronique (6) du capteur comporte pour son équilibrage électronique un potentiomètre pouvant être commandé par voie électronique.

7. Système (2) optique actif de mesure de courant suivant la revendication 1, dans lequel les parties (8, 10) du capteur (4) sont munies respectivement d'un rail (12, 14) de raccordement de courant.

8. Système (2) optique actif de mesure de courant suivant la revendication 1, dans lequel le capteur (4) est en manganine.

9. Système (2) optique actif de mesure de courant suivant la revendication 7, dans lequel les rails (12, 14) de raccordement du courant sont en cuivre.

10. Système (2) optique actif de mesure de courant suivant la revendication 1, dans lequel le capteur (4) est muni d'un autre raccord pour une fibre optique.
